Europäisches Patentamt

European Patent Office

Office européen des brevets

(19)

(11) Numéro de publication : **0 202 985 B1**

# (12) FASCICULE DE BREVET EUROPEEN

(45) Date de publication du fascicule du brevet :
30.01.91 Bulletin 91/05

(51) Int. Cl.⁵ : **H03C 1/60**

(21) Numéro de dépôt : **86400849.5**

(22) Date de dépôt : **18.04.86**

(54) Emetteur d'ondes radio-électriques à bande latérale unique.

(30) Priorité : 24.04.85 FR 8506208

(43) Date de publication de la demande :
26.11.86 Bulletin 86/48

(45) Mention de la délivrance du brevet :
30.01.91 Bulletin 91/05

(84) Etats contractants désignés :
DE GB

(56) Documents cités :
EP-A- 0 112 410
FR-A- 908 223

(56) Documents cités :
US-A- 4 176 319
PATENTS ABSTRACTS OF JAPAN, vol. 6, no.
176 (E-130)[1054], 10 septembre 1982; & JP - A
- 57 92 924 (YAESU MUSEN K.K.) 09-06-1982

(73) Titulaire : THOMSON-CSF
51, Esplanade du Général de Gaulle
F-92800 Puteaux (FR)

(72) Inventeur : Laborde, Georges
Thomson-CSF SCPI
F-92045 PARIS LA DEFENSE CEDEX 67 (FR)

(74) Mandataire : Lincot, Georges et al
THOMSON-CSF SCPI
F-92045 PARIS LA DEFENSE CEDEX 67 (FR)

EP 0 202 985 B1

## Description

La présente invention concerne un émetteur d'ondes radio-électriques à bande latérale unique.

Il est connu pour obtenir un signal modulé selon le principe de modulation à bande latérale unique ci-après désigné par BLU, de séparer le signal BLU à bas niveau en ces deux composantes d'enveloppe ou d'amplitude et de phase pour les appliquer à l'aide de deux voies distinctes de transmission sur une première et une deuxième entrée d'un étage de modulation de l'étage puissance de l'émetteur.

Des exemples de réalisation fonctionnant suivant ce principe sont décrits, par exemple, dans le brevet français FR 908 223 ayant pour titre "Procédé d'amplification d'ondes radio-électriques à bande latérale unique" déposé au nom de la Compagnie Française THOMSON HOUSTON ou encore décrit dans la demande de brevet européen 0112410 ayant pour titre "Einseitenbandsender und ein Verfahren zu dessen Betrieb" déposée au nom de BBC Aktiengesellschaft Brown Boveri & Cie.

L'émetteur décrit dans la demande de brevet européen 0112410 et que l'inventeur présente comme un perfectionnement aux émetteurs décrits par M. L. Khan dans la revue IRE page 803 de juillet 1952 apporte une solution au problème de la transmission de la composante continue du signal audiofréquence dans la voie de transmission de la composante d'enveloppe ou d'amplitude du signal BLU. La solution à ce problème est apportée par l'emploi d'un amplificateur de commutation pour réaliser la modulation d'amplitude, mais l'amplificateur-limiteur qui est placé dans la voie de transmission de la composante de phase, ne permet pas d'appliquer le schéma de réalisation de l'émetteur qui est décrit, aux émetteurs ondes courtes dont la bande de fréquence de travail peut varier, par exemple, entre 1 MHz et quelques dizaines de MHz, du fait qu'à ces fréquences les caractéristiques de la fonction de transfert de l'amplificateur-limiteur varient dans toute la bande de fréquence de travail de l'émetteur. D'autre part, pour compenser les retards de transmission des deux composantes du signal BLU dans chacune des voies de transmission il est prévu, selon un deuxième mode de réalisation, deux modulateurs à bande latérale unique dans chacune des voies de transmission et un dispositif de correction dans la voie de transmission de la composante de phase pour compenser le retard supplémentaire apporté par l'insertion d'un modulateur dans la voie de transmission de la composante d'amplitude.

Outre le fait que l'utilisation de deux modulateurs BLU présente l'inconvénient de conduire à un prix de revient élevé des émetteurs, les filtres qui sont insérés dans ces deux modulateurs, à moins d'être appairés rigoureusement, présentent des écarts de temps de transfert importants qui sont préjudiciables au bon fonctionnement des émetteurs organisés de cette façon.

Le but de l'invention est de pallier les inconvénients précités.

A cet effet, l'invention a pour objet, un émetteur d'ondes radioélectriques à bande latérale unique comprenant une antenne d'émission, un étage de modulation couplé à l'antenne d'émission, un générateur du signal à bande latérale unique à transmettre, ainsi qu'une première et une deuxième voie de transmission couplées en parallèle entre l'étage de modulation et le générateur du signal à bande latérale unique pour partager le signal à bande latérale unique fourni par le générateur en ces deux composantes d'amplitude et de phase, la composante d'amplitude du signal à bande latérale unique étant appliquée par la première voie de transmission sur une première entrée de l'étage de modulation et la composante de phase étant appliquée par la deuxième voie de transmission sur la deuxième entrée de l'étage de modulation de manière, à moduler en amplitude la composante de phase fournie par la deuxième voie de transmission par la composante d'amplitude fournie par la première voie de transmission, caractérisé en ce que, la première voie de transmission de la composante d'amplitude du signal à bande latérale unique comprend un détecteur d'enveloppe du signal à bande latérale unique et un dispositif à retard couplés tous deux en série entre la sortie du générateur à bande latérale unique et la première entrée du modulateur, et en ce que la deuxième voie de transmission de la composante de phase comprend une chaîne d'amplification à fréquence intermédiaire et une chaîne de transposition de fréquence couplées toutes deux en série dans cet ordre entre la sortie du générateur du signal à bande latérale unique et la deuxième entrée du modulateur, la chaîne d'amplification à fréquence intermédiaire comprenant un amplificateur-limiteur et un filtre passe-bande couplés dans cet ordre en série entre la sortie du générateur de signal à bande latérale unique et l'entrée de la chaîne de transposition de fréquence.

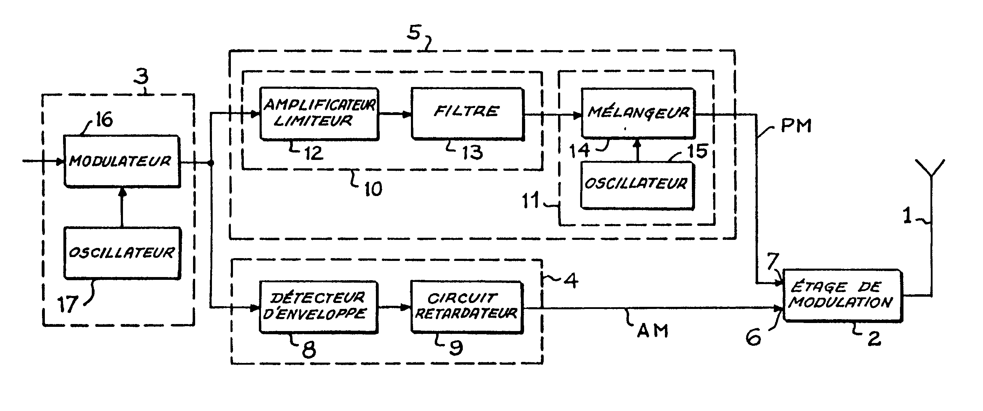

D'autres caractéristiques et avantages de l'invention apparaîtront au cours de la description faite au regard de la figure unique du dessin annexé, donnée uniquement à titre d'exemple, et qui représente la chaîne d'émission d'un émetteur ondes courtes à bande latérale unique selon l'invention.

La chaîne d'émission qui est représentée par le schéma de principe de la figure comprend une antenne 1 alimentée par un étage de modulation 2, l'étage de modulation 2 étant couplé à la sortie d'un générateur de signal à bande latérale unique 3, représenté à l'intérieur d'un rectangle en pointillés, au travers, d'une part, d'une première voie de transmission 4 de la composante d'amplitude ou d'enveloppe du signal à bande latérale unique fourni par le générateur 3 et au travers, d'autre part, d'une deuxième voie de transmission 5 de la composante de phase du signal à bande latérale unique fourni par le générateur 3 représentées toutes deux à l'intérieur de lignes en pointillés. Sur la figure la sortie de la première voie de transmission 4 est couplée directement à une première entrée 6 de l'étage de modulation 2 et la deuxième voie de transmission 5 à sa sortie couplée directement à la deuxième entrée 7 de l'étage de modulation 2. La première voie de transmission 4 de la composante d'amplitude du signal à bande latérale unique comprend un détecteur d'enveloppe 8 et un circuit retardateur 9 tous deux reliés en série dans cet ordre entre la sortie du générateur 3 et l'entrée 6 de l'étage de modulation 2. La deuxième voie de transmission 5 de la composante de phase du signal à bande latérale unique comprend une chaîne d'amplification 10 à fréquence intermédiaire et une chaîne de transposition de fréquence 11 couplées toutes deux en série dans cet ordre entre la sortie du générateur 3 et la deuxième entrée 7 de l'étage de modulation 2. La chaîne de fréquence intermédiaire comprend un amplificateur-limiteur 12 et un filtre 13 qui sont reliés dans cet ordre en série entre la sortie du générateur 3 et l'entrée de la chaîne de transposition 11. La chaîne de transposition 11 comprend de façon connue un étage mélangeur 14 piloté par un oscillateur à fréquence fixe 15. Le générateur de signal à bande latérale unique 3 comprend de façon connue un modulateur 16 piloté par un oscillateur à fréquence fixe 17.

L'étage de modulation 2 effectue le produit des signaux appliqués respectivement sur sa première entrée 6 et sur sa deuxième entrée 7 par les sorties des voies de transmission 4 et 5. Cet étage de modulation peut être réalisé à partir de l'étage d'émission d'un émetteur à modulation d'amplitude sous réserve que la composante continue soit transmise sur le tube d'émission entre l'entrée réservée au signal audiofréquence et l'électrode modulée. Cette dernière disposition aura pour avantage de permettre le fonctionnement de l'émetteur indifféremment dans les modes de modulation à modulation d'amplitude, à double bande latérale, et en bande latérale unique. Dans le mode de fonctionnement à double bande latérale, l'étage de modulation 2 pourra recevoir sur sa première entrée 6 le signal audiofréquence de modulation et sur sa deuxième entrée 7 le signal transportant la fréquence porteuse de sortie de l'émetteur. Par contre dans le mode de fonctionnement en bande latérale unique, conformément à l'invention, l'entrée 6 de l'étage de modulation reçoit le signal enveloppe AM qui transporte l'information d'amplitude du signal à bande latérale unique fourni par le générateur 3 et l'entrée 7 reçoit le signal PM transportant l'information de phase du signal à bande latérale unique. Les deux signaux AM et PM sont obtenus au travers des deux voies de transmission 4 et 5 à partir du générateur 3 qui peut être, dans un mode de réalisation de l'invention, un générateur à faible niveau travaillant en fréquences intermédiaires pour faciliter la réalisation de l'amplificateur-limiteur 12.

Pour que le signal à bande latérale unique qui est reconstitué à la sortie de l'étage de modulation 2 soit correct il faut, qu'en l'absence d'autres distorsions, les signaux AM et PM fournis respectivement par les voies de transmission 4 et 5 soient corrélés en phase au niveau de l'étage modulé. Cette compensation est assurée en insérant un dispositif à retard dans la voie de transmission qui est la plus rapide, comme d'autre part, l'étage de modulation 2 doit pouvoir travailler dans une large bande de fréquences comprise entre par exemple 1 et quelques dizaines de MHz la compensation de retard ainsi que tout le traitement nécessaire pour obtenir les signaux aux entrées 6 et 7 de l'étage de modulation se fait à fréquence intermédiaire ou encore dans la bande de base du signal audiofréquence à transmettre. De la sorte, la transposition de fréquence effectuée par l'étage mélangeur 14 est réalisée juste avant l'entrée 7 de l'étage de modulation 2. Si la voie de transmission du signal AM apparaît être la plus rapide des deux voies, le circuit retardateur 9 est placé dans la voie de transmission 4. La chaîne de transmission de la composante de phase 5 fournit un signal PM d'amplitude constante sur la deuxième entrée 7 du modulateur 2, l'amplitude constante du signal PM étant garantie par l'amplificateur-limiteur 12 qui écrête le signal fourni par la sortie du générateur 3. Comme le signal écrêté par l'amplificateur-limiteur 12 est riche en harmoniques ce signal est appliqué à l'entrée du filtre passe-bande 13 pour l'élimination des fréquences multiples de la fréquence fondamentale du signal fourni par l'amplificateur-limiteur 12. Pour le cas où le retard de transmission serait plus important dans la voie 4 de transmission du signal AM d'un retard $\Delta\tau$, il sera possible de structurer le filtre 13 pour obtenir un retard égal ou supérieur au retard $\Delta\tau$. Il sera aussi possible dans le cas où ce retard est supérieur au retard $\Delta\tau$, d'ajuster à nouveau le circuit retardateur 9 pour corréler les deux retards sur les deux voies de transmission. $\Delta$

## Revendications

1. Emetteur d'ondes radio-électriques à bande latérale unique comprenant une antenne d'émission (1), un étage de modulation (2) couplé à l'antenne d'émission (1), un générateur (3) du signal à bande latérale unique à transmettre ainsi qu'une première (4) et deuxième (5) voies de transmission couplées en parallèle entre l'étage de modulation (2) et le générateur de signal à bande latérale unique (3) pour partager le signal à bande latérale unique fourni par le générateur à bande latérale unique (3) en ces deux composantes d'amplitutde et de phase, la composante d'amplitude du signal à bande latérale unique étant appliquée par la première voie de transmission (4) sur une première entrée (6) de l'étage de modulation (2) et la composante de phase étant appliquée par la deuxième voie de transmission sur la deuxième entrée (7) de l'étage de modulation (2) de manière, à moduler en amplitude la composante de phase fournie par la deuxième voie (5) de transmission par la composante d'amplitude fournie par la première voie (4) de transmission, caractérisé en ce que la première voie de transmission (4) de la composante d'amplitude du signal à bande latérale unique comprend un détecteur d'enveloppe (8) du signal à bande latérale unique et un dispositif à retard (9) couplés tous deux en série entre la sortie du générateur à bande latérale unique (3) et la première entrée (6) du modulateur et en ce que la deuxième voie (5) de transmission de la composante de phase comprend, une chaîne d'amplification à fréquence intermédiaire (10) et une chaîne de transposition de fréquence (11) couplées toutes deux en série dans cet ordre entre la sortie du générateur de signal à bande latérale unique (3) et la deuxième entrée du modulateur (7), la chaîne d'amplification à fréquence intermédiaire (10) comprenant un amplificateur-limiteur (12) et un filtre passe-bande (13) couplés dans cet ordre en série entre la sortie du générateur de signal à bande latérale unique et l'entrée de la chaîne de transposition de fréquence.

2. Emetteur selon la revendication 1, caractérisé en ce que la chaîne de transposition (11) comprend un étage mélangeur de fréquence (14) couplé par une première entrée à la sortie de la chaîne d'amplification à fréquence intermédiaire (10) et par une deuxième entrée à la sortie d'un oscillateur de fréquence fixe (15), la sortie de l'étage mélangeur de fréquence étant couplée à la deuxième entrée de l'étage de modulation (2).

## Claims

1. An SSB transmitter for radio waves, comprising an transmitting antenna (1), a modulating stage (2) coupled with the transmitting antenna (1), an SSB signal generator (3) for an SSB signal to be transmitted and a first (4) and a second (5) transmission path coupled in parallel between the modulating stage (2) and the SSB generator (3) in order to divide the SSB signal provided by the SSB generator (3) into it amplitude and phase components, the amplitude component of the SSB signal being applied via the first transmission path (4) to a first input (6) of the modulation stage (2) and the phase component being applied via the second transmission path to the second input (7) of the modulation stage (2) in such a manner as to modulate in amplitude the phase component supplied by the transmission path (5) by the amplitude component supplied by the first transmission path (4), characterized in that the first transmission path (4) of the amplitude component of the SSB signal comprises an envelope detector (8) for the SSB signal and a delay device (9) both coupled in series between the output of the SSB generator (3) and the first input (6) of the modulator and in that the second transmission path (5) for the phase component comprises an IF amplifier chain (10) and a frequency translating chain (11) both coupled in series in this order between the output of the SSB signal generator (3) and the second input of the modulator (7), the IF amplifier chain (10) comprising a limiting amplifier (12) and a pass band filter (13) coupled in this order in series between the output of the SSB signal generator and the input of the frequency translating device.

2. The transmitter as claimed in claim 1, characterized in that the translating device (11) comprises a frequency mixing stage (14) coupled by a first input with the output of the IF amplifier (10) and by a second input with the output of a fixed frequency oscillator (15), the output of the frequency mixing stage being coupled with the second input of the modulation stage (2).

## Ansprüche

1. Einseitenband-Funksender, mit einer Sendeantenne (1), einer mit der Sendeantenne (1) gekoppelten Modulationsstufe (2), einem Generator (3) für das zu übertragende Einseitenbandsignal sowie mit einem ersten (4) und einem zweiten (5) Übertragungsweg, die zwischen der Modulationsstufe (2) und dem Generator (3) des Einseitenbandsignals parallel geschaltet sind, um das vom Einseitenband-Generator (3) gelieferte Einseitenbandsignal in seine Komponenten der Amplitude und der Phase zu zerlegen, wobei die Ampulitudenkomponente des Einseitenbandsignals über den ersten Übertragungsweg (4) an einen ersten Eingang (6) der Modulationsstufe (2) und die Phasenkomponente über den zweiten Übertragungsweg an den zweiten Eingang (7) der Modulationsstufe (2) so gegeben werden, daß die vom zweiten Übertragungsweg (5) gelieferte Phasenkomponente durch die vom ersten Übertragungsweg (4) gelieferten Amplitudenkomponente amplitudenmoduliert wird, dadurch gekennzeichnet, daß der erste Übertragungsweg (4) der Amplitudenkomponente des Einseitenbandsignals einen Hüllkurvendetektor (8) für das Einseitenbandsignal und eine Verzögerungsvorrichtung (9) umfaßt, die beide zwischen dem Ausgang des Einseitenband-Generators (3) und dem ersten Eingang (6) des Modulators in Reihe geschaltet sind, und daß der zweite Übertragungsweg (5) für die Phasenkomponente eine Zwischenfrequenzverstärkerkette (10) und eine Frequenzumsetzerkette (11) umfaßt, die in dieser Reihenfolge zwischen dem Ausgang des Generators (3) des Einseitenbandsignals und dem zweiten Eingang (7) des Modulators in Reihe geschaltet sind, wobei die Zwischenfrequenzverstärkerkette (10) einen Verstärker-Begrenzer (12) und ein Bandpaßfilter (13) umfaßt, die in dieser Reihenfolge zwischen dem Ausgang des Generators des Einseitenbandsignals und dem Eingang der Frequenzumsetzerkette in Reihe geschaltet sind.

2. Sender gemäß Anspruch 1, dadurch gekennzeichnet, daß die Umsetzerkette (11) eine Frequenzmischstufe (14) umfaßt, die an einem ersten Eingang mit dem Ausgang der Zwischenfrequenzverstärkerkette (10) und an einem zweiten Eingang mit dem Ausgang eines Oszillators (15) fester Frequenz gekoppelt ist, wobei der Ausgang der Mischfrequenzstufe mit dem zweiten Eingang der Modulationsstufe (2) gekoppelt ist.

MODULATEUR

OSCILLATEUR

AMPLIFICATEUR LIMITEUR

FILTRE

MÉLANGEUR

OSCILLATEUR

DÉTECTEUR D'ENVELOPPE

CIRCUIT RETARDATEUR

ÉTAGE DE MODULATION

PM

AM

EP 0 202 985 B1